Europäisches Patentamt

European Patent Office

Office européen des brevets

(19)

(11) Publication number: **0 116 651 B1**

(12) **EUROPEAN PATENT SPECIFICATION**

(45) Date of publication of patent specification: **06.05.92**

(51) Int. Cl.5: **H01L 29/74**, H01L 31/111, H01L 27/14

(21) Application number: **83902701.8**

(22) Date of filing: **30.08.83**

(86) International application number: **PCT/JP83/00284**

(87) International publication number: **WO 84/01054 (15.03.84 84/07)**

(54) PHOTOTHYRISTOR.

(30) Priority: **30.08.82 JP 150300/82**

(43) Date of publication of application: **29.08.84 Bulletin 84/35**

(45) Publication of the grant of the patent: **06.05.92 Bulletin 92/19**

(84) Designated Contracting States: **DE GB NL**

(56) References cited:
EP-A- 0 064 561
DE-A- 3 011 484
FR-A- 2 050 630
FR-A- 2 299 727
JP-A-53 124 086

REVUE DE PHYSIOUE APPLIOUEE, vol. 13, no. 12, December 1978, pages 725-728, Paris, FR; J. NISHIZAWA et al.: "Static induction thyristor"

(73) Proprietor: **NISHIZAWA, Junichi**
**6-16, Komegafukuro 1-chome**
**Sendai-shi Miyagi 980(JP)**

(72) Inventor: **NISHIZAWA, Junichi**
**6-16, Komegafukuro 1-chome**
**Sendai-shi Miyagi 980(JP)**

(74) Representative: **Sunderland, James Harry et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(-/2.18/2.0)

EP 0 116 651 B1

# Description

The present invention relates to a high-speed and high-sensitivity semiconductor device and, more particularly, to a photo thyristor.

## BACKGROUND ART

Conventional thyristors of a p-n-p-n structure are high in base resistance, and hence possess the defects that they are not sensitive enough to light and low in operating speed.

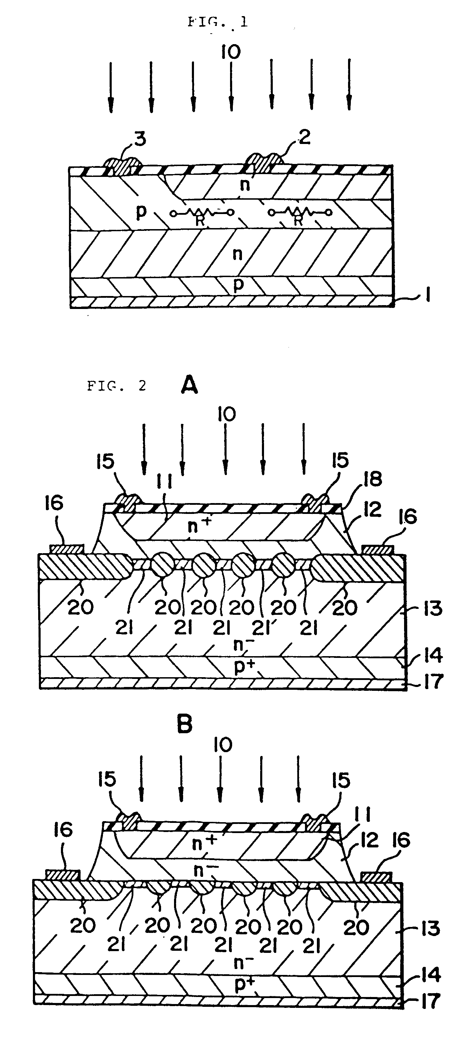

Fig. 1 shows a conventional light trigger thyristor. This has a p-n-p-n four-layered structure, 1 being an anode electrode, 2 a cathode electrode and 3 a gate electrode. 10 is a light input directed to the thyristor.

When irradiated by light, the thyristor conducts. Sometimes the gate electrode 3 is not led out. Since the conventional light trigger thyristor has a high resistance p-type base, as shown in Fig. 1, it takes time for the entire device to turn ON. Because of this, the frequency at which the thyristor can be switched is very low.

An object of the present invention is to provide a photo thyristor which has higher photo sensitivity and faster switching operation than the abovesaid conventional light trigger thyristor.

FR-A-2 050 630 discloses a photo thyristor device n-p-n-p structure. This structure has a top, emitter layer of n-type. A part of the upper surface of this layer is masked by a metal electrode, preventing light from entering the device where the upper surface is masked. This partial masking is said to give rise to problems. Below the emitter layer is a p-type base layer which is provided with a portion of higher longitudinal resistance than another portion of that layer, which other portion is accessible to light (not masked). Below the base layer are an n-type layer and a p-type layer.

FR-A-2 299 727 discloses a thyristor structure having, in order:-

an injection layer, of a first conductivity type;

a blocking layer, lightly doped, of a second conductivity type;

a control layer, moderately doped, of the first conductivity type; and

an emitter layer, heavily doped, of the second conductivity type.

There is embedded within the moderately doped control layer, spaced from the emitter layer, a grid constituted by a heavily doped conduction layer.

Review de Physique Appliquée, Vol. 13, December 1978, page 725 to 728, discloses a static induction thyristor structure having, in order:-

a $n^+$ layer;

a $n^-$ layer; and

a $p^+$ layer.

Within the $n^-$ layer, $p^+$ regions are provided as shown in Fig. 1 of the disclosure.

DE-A-30 11 484 discloses a static induction thyristor having, in order:-

an $n^+$ cathode layer;

an i ($n^-$) channel layer;

an n, relatively thin and low resistance, layer; and

a $p^+$ anode layer.

Within the channel layer, between the $n^+$ and n layers, strip or grid-like $p^+$ gate regions are provided, as shown in Fig. 1(c) of the disclosure. This static induction thyristor may also be of surface-gate type (of Fig. 1 (a)).

According to the present invention there is provided a photo thyristor comprising the following sequence of sublayers:-

a first region, being a cathode region, of a first conductivity type, doped to a high level and extending along the face of the thyristor over which incident light is received for activating the thyristor;

a second region, of the first conductivity type, doped to a low level;

a third region, being a gate region, consisting of zones of a second conductivity type, opposite to the first conductivity type, of different impurity densities, the zones being distributed across a plane perpendicular to current flow and forming a continuous layer;

a fourth region, of the first conductivity type, doped to a low level; and

a fifth region, being an anode region, of the second conductivity type;

the distribution of the zones of different impurity densities extending across a part of the gate region in register with a light-receiving part of said face;

high impurity density zones of said part of the gate region directly contacting one of the second and fourth regions of the first conductivity type and either the other one of said regions of the first conductivity type or a gate electrode;

whereby optically excited minority carriers whose type is the same as the conductivity type of the gate region are stored in high impurity density zones of the gate region whilst majority carriers which are injected from the cathode and whose type is opposite to that of the optically excited minority, carriers are permitted to pass easily through low impurity density zones of the gate region, the high and low impurity density zones of the gate region being capacitively coupled together.

With the abovesaid arrangement, the present invention permits the reduction of the gate resistance, allows a high-speed operation and raises the photo sensitivity very high.

## BRIEF DESCRIPTION OF THE DRAWINGS

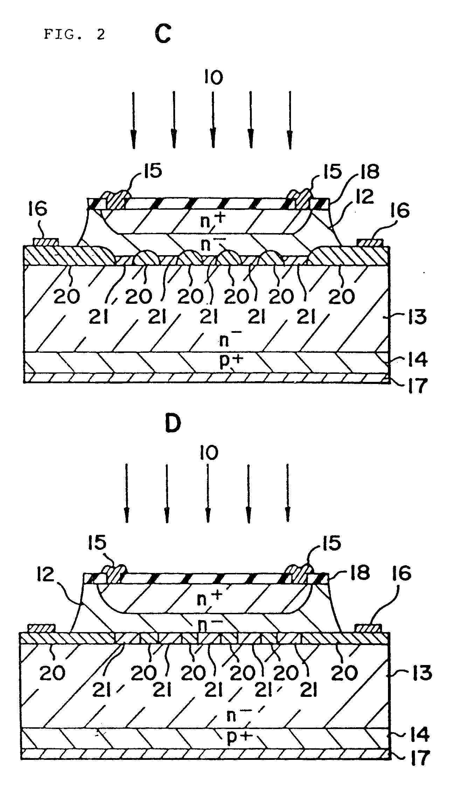

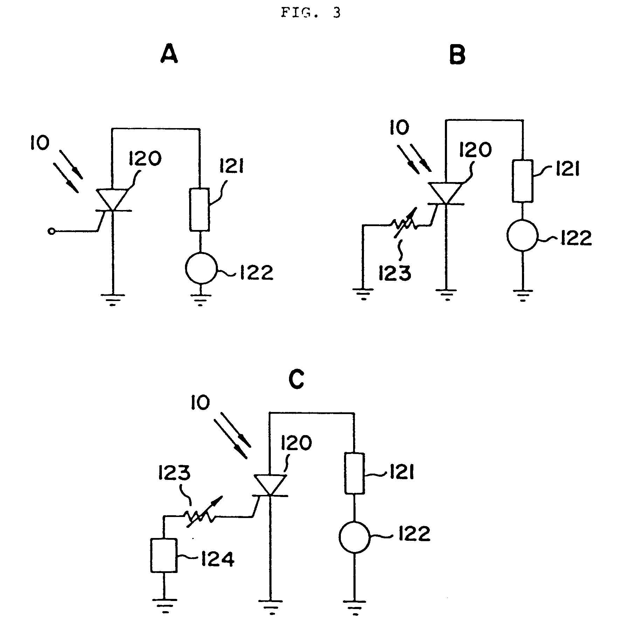

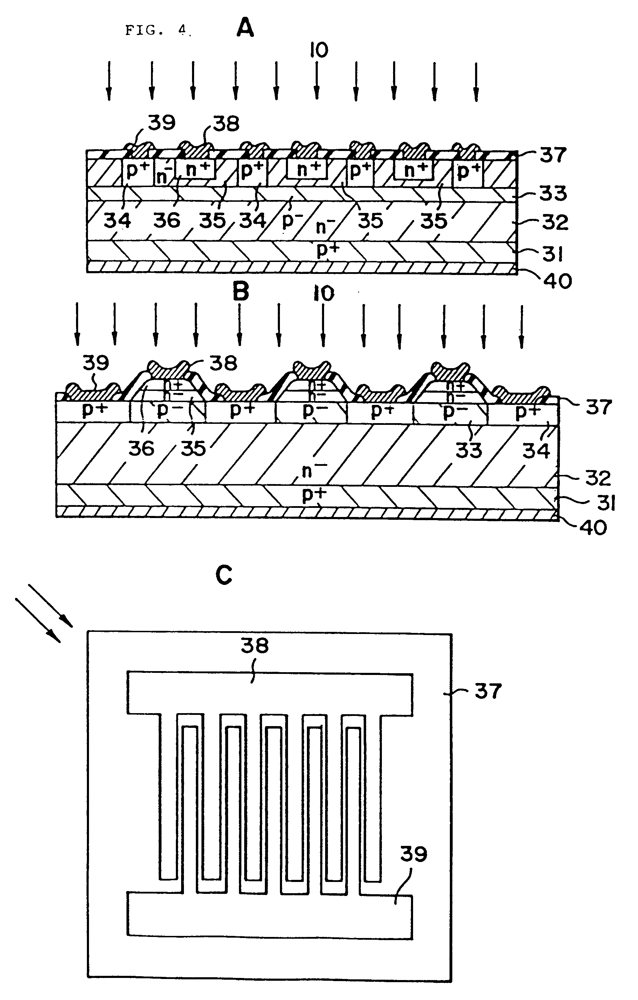

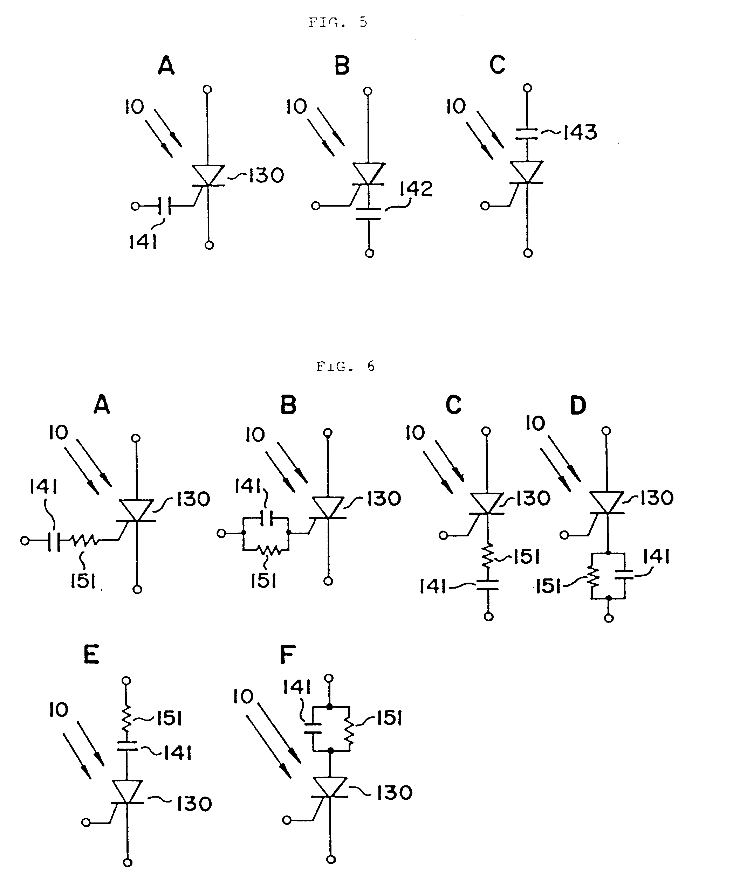

Fig. 1 is a schematic cross-sectional view of a conventional light trigger thyristor; Figs. 2A to D illustrate embodiments of the present invention in which high impurity density regions of their p-type bases (gates) are of different shapes; Fig. 3 shows, by way of example, operating circuits for a light trigger thyristor according to the present invention, A being the case where the gate is open, B an example in which the sensitivity is made variable by an external gate resistance and C an embodiment in which a gate voltage circuit is provided for turning OFF the gate; Figs. 4A to C illustrate other embodiments of the present invention; Figs. 5A to C embodiments of operating circuits in each of which a capacitor is connected to the gate, cathode and anode of the light trigger thyristor of the present invention respectively; and Figs. 6A to F illustrate other embodiments of the operating circuit for the light trigger thyristor of the present invention.

## BEST MODE FOR CARRYING OUT THE INVENTION

With reference to the drawings, the present invention will hereinafter be described in detail.

Fig. 2A illustrates an embodiment of the present invention. Reference numeral 13 indicates an n-type high resistivity silicon substrate. By a selective diffusion of boron, there are formed a $p^+$ region 14 which will ultimately serve as an anode and high impurity density regions 20 of a p gate. A high resistivity $n^-$ layer 12 is grown about 10 $\mu$m thick on the p gate 20 by means of a vapor growth method using, for example, $SiCl_4$ and $H_2$ gas. During the growth relatively low impurity density P gate regiors 21 are formed by autodoping from the high impurity density regions 20 of the P gate simultaneously with the epitaxial growth of the abovesaid layer. Next, a high impurity $n^+$ region 11 of a cathode is formed using phosphorus. The high impurity density regions 20 of the p gate are partly exposed by chemical etching, as shown. By vapor deposition of aluminum in a high vacuum, a cathode electrode 15, a gate electrode 16 and an anode electrode 17 are formed. To facilitate sufficient irradiation of operation layers by the optical input 10, the cathode electrode 15 is provided, not all over the cathode, but only at the peripheral portion thereof.

A description will be given of the operation of this embodiment. In its forward blocking state and reverse blocking state this thyristor operates in the same manner as does an ordinary thyristor. Upon creation of electron-hole pairs by the optical input 10, electrons flow across the high resistance $n^-$ region to gather in the vicinity of the $n^- p^+$ junction between the $n^-$ region and the anode. On the other hand, holes positively charge the high impurity density regions 20 of the p gate, reducing the potential barrier between the cathode and the gate to switch the thyristor to the ON state. At this time, the electrons from the cathode pass mainly through the low impurity density regions 21 of the p gate region which are low in diffusion potential. Since the resistance of the p gate is made much lower than in the conventional thyristor owing to the presence of the high impurity density regions 20, the photo sensitivity rises very high. The electrostatic capacitance between the cathode and the gate electrode is also reduced by the presence of the high resistivity region 12 between the p gate regions 20 and 21 and the $n^+$ cathode region 11. Since the time constant decreases (the time constant being the product of the gate resistance and the capacitance between the cathode and the gate), the switching speed becomes very high.

The conventional thyristor has the disadvantage of difficulty in speeding up its operation because much time is consumed until the entire device is turned ON after the gate electrode and its vicinity are turned ON. With the thyristor of the present invention, however, since the p gate has its high impurity density regions arranged all over the device to thereby reduce the gate resistance, the time for turning ON the entire device can be cut down.

The high impurity density regions 20 in the p gate region shown in Fig. 2A need only to be provided in a parallel-line, grid-like, mesh-like or honeycomb form. In Fig. 2A the high impurity density regions 20 of the p gate are formed thicker than the low impurity density regions of the p base, causing the electrons from the cathode to be injected exclusively through the low impurity density p gate regions 21.

It is desirable for raising the injection efficiency that the impurity densities of the anode region 14 and the cathode region 11 be as high as possible. Their impurity densities are selected higher than about $1 \times 10^{18}$ cm$^{-13}$. It is desirable that the impurity density of the high impurity density regions 20 of the p type gate be as high as possible, and it is selected to by approximately $1 \times 10^{18}$ cm$^{-3}$. Boron largely differs in its covalent bonding radius from silicon, and in the case where it is diffused into an $n^-$ substrate, since dislocations occur due to lattice mismatching at a density ex-

ceeding about $1 \times 10^{19} \mathrm{cm}^{-3}$, it is necessary to prevent the occurrence of lattice distortions by simultaneously adding a Group IV element, such as, for example, germanium or tin, thereby raising the boron density as high as possible.

The impurity density of the high resistivity $n^-$ channel region is selected lower than $1 \times 10^{14} \mathrm{cm}^{-3}$ or so, and its thickness is determined in accordance with the forward blocking voltage that it is desired to obtain. With a resistivity of approximately 500 $\Omega$cm and a thickness of 300 $\mu$m, a forward blocking voltage of between some 600 to 700 V can be obtained. The forward and reverse blocking voltages are dependent mainly upon the surface treatment of the device, and a breakdown voltage up to 10 KV or so can be achieved by a double bevelled structure, a double positive bevelled structure and a vacuum baking step after mesa etch, resin coating and a package having sealed therein an inert gas.

Figs. 2B to D illustrate other embodiments of the invention in which the high impurity density regions 20 and the low impurity density regions 21 are formed in different shapes through using different manufacturing steps. In Fig. 2B the junction portion between the gate and the cathode is flat and the p$^+$ regions 20 of the gate project out to the side of the junction between the gate and the anode. In Fig. 2C the p$^+$ regions 20 of the gate project out towards the cathode unlike in Fig. 2B. In Fig. 2D the gate portion is formed uniformly thick.

Figs. 3A to C show embodiments of ON-OFF circuits using photo thyristors embodying the present invention. Fig. 3A shows the case where the gate electrode is made floating without any particular connection thereto, and the photo thyristor 120 of the present invention is turned ON by the optical input 10. Reference numeral 121 indicates a load and 122 an anode-cathode power source. This is an embodiment in which the thyristor is turned OFF by cutting off the optical input 10 to reduce the anode voltage lower than a holding current, or by a commutation circuit.

The embodiment shown in Fig. 3B shows an example in which since the base resistance of the photo thyristor of the present invention is low, an external resistor 123 is made variable, thereby improving the turn-ON sensitivity higher than in the case of Fig. 3A.

Shown in Fig. 3C is an embodiment in which the thyristor is turned OFF by applying a reverse voltage to the gate electrode, instead of using the commutation circuit and lowering the holding current by reducing the anode-cathode voltage as in the cases of Figs. 3A and B. Reference numeral 124 designates a circuit for generating a reverse voltage which is applied across the gate and cathode.

By applying the highest possible reverse voltage within the range of the breakdown voltage across the cathode and the gate, the main current cutoff performance can be improved and the turn-OFF time can be shortened; namely, the turn-OFF time can easily be reduced less than 1 $\mu$sec.

It is also possible to employ turn-OFF circuits utilizing a gate C, R circuit and R, L circuit, in addition to the embodiments shown in Fig. 3.

Figs. 4A to C illustrate other embodiments of the present invention. These embodiments have such a structure that the high impurity density regions of the p type gate are all interconnected through metallic wiring so as to reduce the gate resistance and the stray capacitance between the cathode and the gate electrode.

In Fig. 4A, reference numeral 31 indicates a p type high impurity density anode region, 32 a high resistivity $n^-$ or intrinsic semiconductor region, 34 high impurity density p type gate regions, 33 a p type gate region lower in impurity density than the gate regions 34, 35 high resistivity $n^-$ or intrinsic semiconductor regions of a cathode region, 36 high impurity density cathode regions and 37 an $SiO_2$ film. Reference numerals 38, 39 and 40 identify cathode, gate and anode electrodes, respectively. By the metallic interconnection of the gate electrodes on the surfaces thereof, the gate resistance is reduced markedly more than in the embodiments shown in Fig. 2.

In the embodiment of Fig. 4B, the high impurity density regions 34 of the p type gate are formed to underlie the cathode, thereby reducing the gate resistance and diminishing an excess inter-electrode capacitance between the cathode and gate as in the embodiment of Fig. 4A.

In Fig. 4B, the high impurity density regions 34 of the p type gate can be formed deep by chemical etching, plasma etching or a method employing an $SiO_2$ film and an $Si_3N_4$ film. P$^-$ high resistivity regions 33 are high resistivity gate regions, which are capacitively coupled with the high impurity density gate regions 34.

Fig. 4C is a top plan view of the semiconductor device of the embodiment shown in Fig. 4B. Reference numeral 38 indicates a cathode electrode and 39 a gate electrode, both of which are comb-shaped.

Figs. 5A and C illustrate other embodiments of the photo thyristor of the present invention in which a capacitor is connected to the gate, cathode and anode electrodes, respectively. By connecting capacitors 141, 142 and 143 to the respective electrodes of a photo thyristor 130, the photo thyristor of the present invention can store a light signal provided by the optical input 10 in the capacitor connected to each electrode. The photo thyristor of the present invention, equipped with such a function, can also be applied to a random access image sensor for optical information and various image sensors having a storage function.

Figs. 6A and B illustrate other embodiments of the photo thyristor of the present invention in which the capacitor 141 and a resistor 151 are connected to its gate electrode. The utilization of the CR time constant extends the function of the photo thyristor. Figs. 6C to F show other embodiments in which the cathode and the anode have the CR time constant.

While the photo thyristors described above each use the p base as the gate, it is needless to say that its conductivity type can be reversed.

The material for the photo thyristor of the present invention is not limited specifically to silicon but may also be germanium, or GaAs and InP which are the Group III-V compound semiconductors, $Ga_{1-x}Al_xAs$, InGaP, InGaAsP and so forth which are mixed cristals thereof, or the Group II-VI compound semiconductors. Further, the thyristor of the present invention is usable not only with light but also with an electron beam and a charged particle beam.

AVAILABILITY FOR INDUSTRIAL USE

As has been described in the foregoing, the photo thyristor of the present invention has the characteristics of high-speed operation and high sensitivity and is of wide use for processing of various optical signals, such as, for example, a random access image sensor for optical information and various image sensors equipped with a storage function.

Claims

1. A photo thyristor comprising the following sequence of sublayers:-

a first region, being a cathode region (11; 36), of a first conductivity type, doped to a high level and extending along the face of the thyristor over which incident light (10) is received for activating the thyristor;

a second region (12; 35), of the first conductivity type, doped to a low level;

a third region, being a gate region (20, 21; 34, 33), consisting of zones of a second conductivity type, opposite to the first conductivity type, of different impurity densities, the zones being distributed across a plane perpendicular to current flow and forming a continuous layer;

a fourth region (13; 32), of the first conductivity type, doped to a low level; and

a fifth region (14; 31), being an anode region, of the second conductivity type;

the distribution of the zones of different impurity densities extending across a part of the gate region (20, 21; 34, 33) in register with a light-receiving part of said face;

high impurity density zones (20; 34) of said part of the gate region directly contacting one of the second and fourth regions (12, 13; 32, 35) of the first conductivity type and either the other one of said regions (12, 13; 32, 35) of the first conductivity type or a gate electrode (39);

whereby optically excited minority carriers whose type is the same as the conductivity type of the gate region (20, 21; 34, 33) are stored in high impurity density zones (20; 34) of the gate region whilst majority carriers which are injected from the cathode and whose type is opposite to that of the optically excited minority carriers are permitted to pass easily through low impurity density zones (21; 33) of the gate region, the high and low impurity density zones of the gate region being capacitively coupled together.

2. A photo thyristor as claimed in claim 1, wherein the said high impurity density zones (20) contact said second and fourth regions (12, 13) of the first conductivity type, above and below the gate region (20, 21).

3. A photo thyristor as claimed in claim 1, wherein the said high impurity density zones (34) contact one of said second and fourth regions of the first conductivity type (32; 35) and the gate electrode (39).

**Revendications**

1. Photothyristor comprenant la succession suivante de souscouches :

une première région, qui est une région de cathode (11; 36), d'un premier type de conductivité, dopée à un niveau élevé et s'étendant le long de la face du thyristor sur laquelle la lumière incidente (10) est reçue pour l'activation du thyristor;

une deuxième région (12; 35), du premier type de conductivité, dopée à un niveau faible;

une troisième région, qui est une région de grille (20, 21; 34, 33), consistant en zones d'un deuxième type de conductivité, opposé au premier type de conductivité, de différentes densités d'impureté, les zones étant réparties sur un plan perpendiculaire au passage du courant et formant une couche continue;

une quatrième région (13; 32), du premier type de conductivité, dopée à un niveau faible; et

une cinquième région (14; 31), qui est une région d'anode, du deuxième type de conductivité;

la répartition des zones de densités d'impureté différentes s'étendant sur une partie de la région de grille (20, 21; 34, 33) en concordance avec une partie de réception de lumière de ladite face;

les zones à densité d'impureté élevée (20; 34) de ladite partie de la région de grille étant directement en contact avec une des deuxième et quatrième régions (12, 13; 32, 35) du premier type de conductivité et avec ou bien l'autre desdites régions (12, 13; 32, 35) dudit premier type de conductivité ou bien une électrode de grille (39);

si bien que des porteurs minoritaires optiquement excités dont le type est le même que le type de conductivité de la région de grille (20, 21; 34, 33) sont emmagasinés dans les zones à densité d'impureté élevée (20; 34) de ladite région de grille, tandis que des porteurs majoritaires qui sont injectés depuis la cathode et dont le type est opposé à celui des porteurs minoritaires optiquement excités sont facilement laissés passer au travers des zones de densité d'impureté faible (21; 33) de la région de grille, les zones de densités d'impureté élevée et faible de la région de grille étant couplées ensemble par capacité.

2. Photothyristor selon la revendication 1, où lesdites zones à densité d'impureté élevée (20) sont en contact avec lesdites deuxième et quatrième régions (12, 13) du premier type de conductivité, au-dessus et au-dessous de la région de grille (20, 21).

3. Photothyristor selon la revendication 1, où lesdites zones à densité d'impureté élevée (34) sont en contact avec une desdites deuxième et quatrième régions du premier type de conductivité (32 ; 35) et l'électrode de grille (39).

**Patentansprüche**

1. Photothyristor mit folgender Folge aus Unterschichten: einem einen Kathodenbereich (11, 36) bildenden, auf einen hohen Pegel dotierten und sich längs der das einfallende Licht (10) zur Aktivierung des Thyristors empfangenden Oberseite erstreckenden ersten Bereich eines ersten Leitfähigkeitstyps, einem auf einen niedrigen Pegel dotierten zweiten Bereich (12, 35) des ersten Leitfähigkeitstyps, einem einen Gatebereich (2, 21; 34, 33) bildenden, aus Zonen eines zum ersten Leitfähigkeitstyp entgegengesetzten zweiten Leitfähigkeitstyps verschiedener Verunreinigungsdichte bestehenden dritten Bereich, wobei die Zonen über einer Ebene senkrecht zum Stromfluß verteilt sind und eine kontinuierliche Schicht bilden, einem auf einen niedrigen Pegel dotierten vierten Bereich (13; 32) des ersten Leitfähigkeitstyps, und einem einen Anodenbereich bildenden fünften Bereich (14; 31) des zweiten Leitfähigkeitstyps, wobei sich die Verteilung der Zonen verschiedener Verunreinigungsdichten über einen mit einem Lichtempfangsteil der Oberseite deckungsgleichen Teil des Gatebereichs (20, 21; 34, 33) erstreckt, wobei Zonen (20; 34) höherer Verunreinigungsdichte des Teils des Gatebereichs einen der zweiten oder vierten Bereiche (12, 13; 32, 35) des erten Leitfähigkeitstyps und entweder den anderen der genannten Bereiche (12, 13; 32, 35) des ersten Leitfähigkeitstyps oder eine Gateelektrode (39) direkt kontaktieren, wobei optisch angeregte Minoritätsträger, deren Typ der gleiche wie der Leitfähigkeitstyp des Gatebereiches (20, 21; 34, 33) ist, in Zonen (20; 34) hoher Verunreinigungsdichte des Gatebereiches gespeichert sind, während Minoritätsträger, die von der Kathode injiziert sind und deren Typ entgegengesetzt zu jenem der optisch angeregten Minoritätsträger ist, leicht durch die Zonen (21; 33) niederer Verunreinigungsdichte des Gatebereiches hindurchgehen können, wobei die Zonen hoher und niedriger Verunreinigungsdichte des Gatebereiches kapazitiv aneinander gekoppelt sind.

2. Photothyristor nach Anspruch 1, wobei die Zonen (20) hoher Verunreinigungsdichte den zweiten und vierten Bereich (12, 13) des ersten Leitfähigkeitstyps ober- und unterhalb des Gatebereichs (20, 21) kontaktieren.

3. Photothyristor nach Anspruch 1, wobei die Zonen (34) hoher Verunreinigungsdichte die Gateelektrode (39) und entweder den zweiten oder den vierten Bereich (32; 35) des ersten Leitfähigkeitstyps kontaktieren.

FIG. 1

FIG. 2

A

B

FIG. 2

C

D

FIG. 3

A

B

C

FIG. 4.

**A**

10

39 38

37

| $p^+$ | $n^-$ | $n^+$ | $p^+$ | $n^+$ | $p^+$ | $n^+$ | $p^+$ |

33

34 36 35 34 $p^-$ $n^-$ 35 35

32

$p^+$

31

40

**B**

10

39 38

$n^+$

| $p^+$ | $p^-$ | $p^+$ | $n^+$ | $p^+$ | $n^+$ | $p^+$ |

37

36 35

33 34

$n^-$

32

$p^+$

31

40

**C**

38

37

39

FIG. 5

FIG. 6